# EUROPEAN PATENT APPLICATION

(11) **EP 4 804 738 A1**
(43) Date of publication of application: **09.09.2026**
(21) Application number: 24885725.2
(22) Date of filing: 29.10.2024
(51) Int. Cl.: H05K 3/46

(54) **WIRING BOARD AND SEMICONDUCTOR DEVICE**

(30) Priority: 31.10.2023 JP 2023186614
(71) Applicant: Kyocera Corporation, Kyoto-shi, Kyoto 612-8501 (JP)
(72) Inventor: ITOU, Seiichirou, Kyoto-shi, Kyoto 612-8501 (JP); GONDO, Iori, Kyoto-shi, Kyoto 612-8501 (JP); HARAZONO, Masaaki, Kirishima-shi, Kagoshima 899-4312 (JP)
(74) Representative: Viering, Jentschura & Partner mbB Patent- und Rechtsanwälte
(86) International application number: PCT/JP2024/038585
(87) International publication number: WO 2025/094958

(57) **Abstract**

A wiring board according to the present disclosure includes a first base member, a second base member containing a plurality of inorganic particles, made of an organic resin, and bonded to the first base member, and a wiring line located in the second base member. The first base member has a higher rigidity than the second base member. The second base member includes a first organic resin layer and a second organic resin layer layered on the first organic resin layer. When a region facing the wiring line in an interface region of the first organic resin layer with the second organic resin layer is defined as a first wiring region and a region facing the second organic resin layer in the interface region is defined as a first bonding region, a content ratio of the inorganic particles in the first bonding region is lower than a content ratio of the inorganic particles in the first wiring region.

## Description

### TECHNICAL FIELD

The present disclosure relates to a wiring board and a semiconductor device.

### BACKGROUND OF INVENTION

A wiring board is known in which an organic substrate having wiring lines formed thereon is layered on a glass cloth substrate as a core material. The organic substrate includes a plurality of organic resin layers, and each organic resin layer contains inorganic particles such as silica (Patent Document 1).

### CITATION LIST

### PATENT LITERATURE

Patent Document 1: JP 2014-27212 A

### SUMMARY

A wiring board according to the present disclosure includes a first base member, a second base member containing a plurality of inorganic particles, made of an organic resin, and bonded to the first base member, and a wiring line located in the second base member. The first base member has a higher rigidity than the second base member. The second base member includes a first organic resin layer and a second organic resin layer layered on the first organic resin layer. When a region facing the wiring line in an interface region of the first organic resin layer with the second organic resin layer is defined as a first wiring region and a region facing the second organic resin layer in the interface region is defined as a first bonding region, a content ratio of the inorganic particles in the first bonding region is lower than a content ratio of the inorganic particles in the first wiring region.

### BRIEF DESCRIPTION OF THE DRAWINGS

FIG. 1 is a schematic cross-sectional view illustrating a state in which a semiconductor device according to an embodiment is mounted over a motherboard.
FIG. 2 is a schematic cross-sectional view illustrating a configuration of a wiring board according to an embodiment.
FIG. 3 is a schematic cross-sectional view illustrating a configuration of a second base member according to an embodiment.
FIG. 4 is a schematic cross-sectional view illustrating a configuration of a first base member and the second base member according to an embodiment.
FIG. 5 is a schematic view for describing a method for manufacturing the second base member according to an embodiment.
FIG. 6 is a schematic view for describing a method for manufacturing the second base member according to an embodiment.
FIG. 7 is a schematic view for describing a method for manufacturing the second base member according to an embodiment.

### DESCRIPTION OF EMBODIMENTS

Modes (hereinafter, referred to as "embodiments") for implementing a wiring board and a semiconductor device according to the present disclosure are described in detail below with reference to the drawings. Note that the present disclosure is not limited by the embodiments. The embodiments can be appropriately combined within a range that does not cause inconsistencies in the processing content. In the following embodiments, the same portions are denoted by the same reference signs, and redundant descriptions are omitted.

In the following embodiments, expressions such as "certain", "orthogonal", "perpendicular", and "parallel" may be used, but these expressions need not mean exactly "certain", "orthogonal", "perpendicular", and "parallel". In other words, each of the expressions described above allows for deviations in, for example, manufacturing accuracy, or installation accuracy.

In the drawings to be referenced below, to facilitate understanding, an orthogonal coordinate system may be defined, in which the X-axis direction, Y-axis direction, and Z-axis direction mutually orthogonal are specified, and the Z-axis positive direction is set as the vertically upward direction.

Inorganic particles have an effect of enhancing the electrical characteristics of a base member made of an organic resin, but may reduce adhesiveness between organic resin layers.

The present disclosure provides a technique capable of improving adhesiveness between organic resin layers while enhancing the electrical characteristics of a base member made of an organic resin by inorganic particles.

### Embodiment

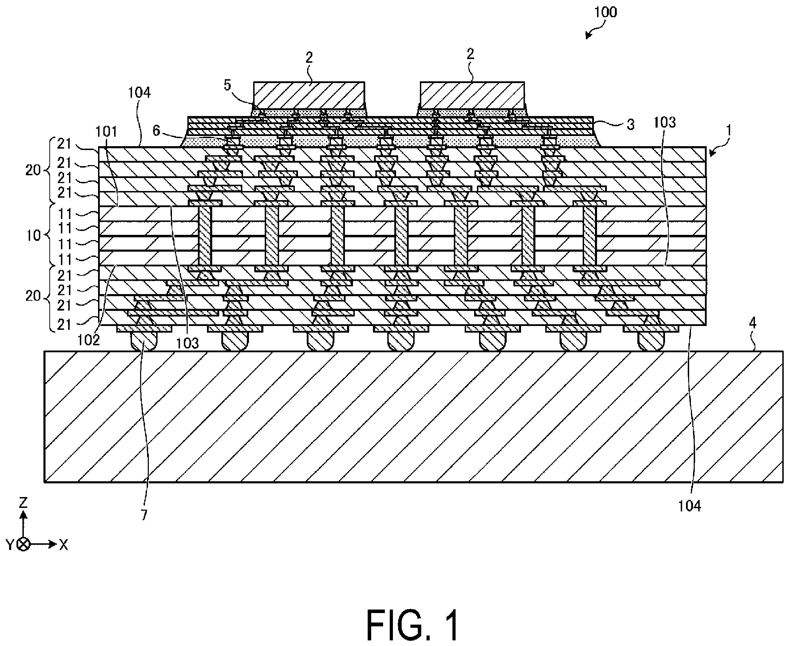

First, a configuration of a semiconductor device 100 according to an embodiment is described with reference to FIG. 1. FIG. 1 is a schematic cross-sectional view illustrating a state in which the semiconductor device 100 according to an embodiment is mounted over a motherboard 4.

As illustrated in FIG. 1, the semiconductor device 100 includes a wiring board 1, a plurality of semiconductor elements 2, and a relay substrate 3.

The wiring board 1 is mounted over the motherboard 4. Details of the wiring board 1 are described below.

The semiconductor element 2 is mounted over the wiring board 1 via the relay substrate 3. The semiconductor element 2 is, for example, a chip or a chiplet in which a circuit or an element is formed on a substrate made of a material other than a semiconductor, such as a semiconductor chip or a glass substrate. A chiplet is a functional block constituting a part of an integrated circuit of the semiconductor device 100.

Although FIG. 1 illustrates two semiconductor elements 2, the semiconductor device 100 may include three or more semiconductor elements. The semiconductor device 100 may include only one semiconductor element 2. For example, when the semiconductor element 2 is a chiplet, an integrated circuit having one function may be configured by a plurality of semiconductor elements 2.

The relay substrate 3 is a so-called interposer, and relays electrical connection between the wiring board 1 and the semiconductor element 2. The relay substrate 3 is bonded to the semiconductor element 2 via bonding portions 5 and is bonded to the wiring board 1 via bonding portions 6. The bonding portions 5 and 6 are, for example, solder. The Young's modulus of the relay substrate 3 may be smaller than the Young's modulus of the wiring board 1. In this case, the relay substrate 3 may have flexibility that allows the relay substrate 3 to be deformed according to the shape of a surface of the wiring board 1.

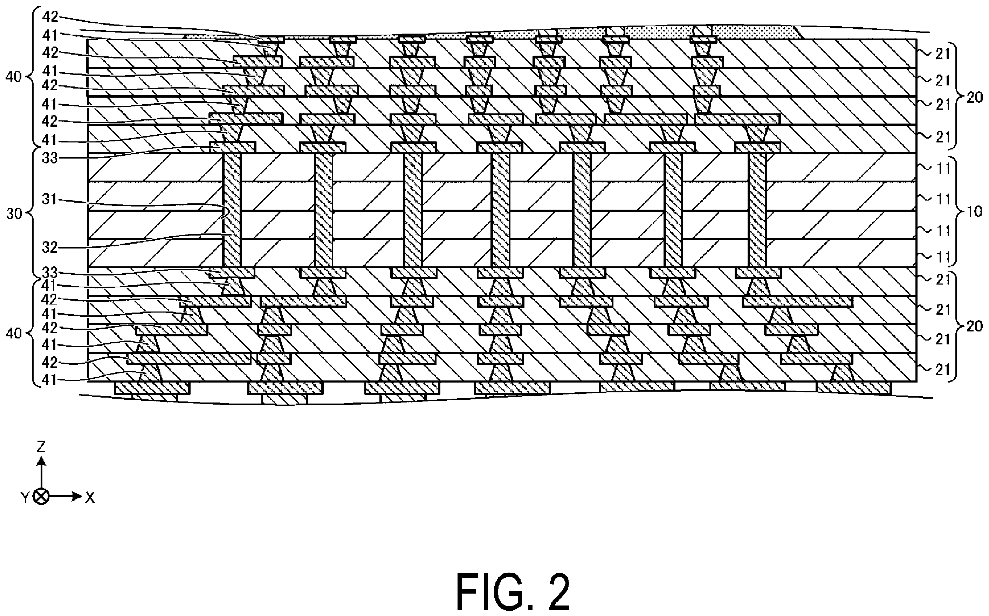

The configuration of the wiring board 1 according to the embodiment is described with reference to FIG. 2. FIG. 2 is a schematic cross-sectional view illustrating the configuration of the wiring board 1 according to the embodiment.

The wiring board 1 includes a first base member 10 and a second base member 20. The wiring board 1 is a laminate body of the first base member 10 and the second base member 20. The wiring board 1 includes a first wiring line 30 and a second wiring line 40.

### First Base Member

The first base member 10 is a base member made of ceramic. The first base member 10 may be formed using a ceramic composite material including a glass component, so-called glass ceramic. The glass ceramic may be any one of a composite of a glass phase and ceramic particles, a composite of a glass phase and a crystal phase formed by crystallization of a part of the glass phase, a form in which ceramic particles are present in a glass phase, and a form in which a glass phase is present at a grain boundary between ceramic particles. The first base member 10 formed using ceramic in this manner has a higher rigidity than a core material made of glass.

For example, the first base member 10 may be low temperature co-fired ceramics (LTCC). When LTCC is used as the first base member 10, a metal having a low melting point such as copper or silver having a relatively low electric resistance can be used as the wiring line.

The first base member 10 may include a ceramic filler as the ceramic particles. As the ceramic filler, for example, alumina (aluminum oxide), calcium titanate, magnesium titanate, or the like can be used. In particular, the first base member 10 including alumina has a high rigidity.

The first base member 10 includes a first surface 101 and a second surface 102 opposite to the first surface 101. The first base member 10 may be a plate-shaped body having the first surface 101 and the second surface 102 as main surfaces. In the present embodiment, the metal having a low melting point is a metal having a lower melting point than a general metal used for a wiring line of a ceramic base member, for example, tungsten or molybdenum.

In the embodiment, the first base member 10 includes a plurality of ceramic layers 11. The plurality of ceramic layers 11 are layered along the thickness direction of the first base member 10. The wiring board 1 including such a first base member 10 has a high degree of freedom in design. By configuring the first base member 10 using the plurality of ceramic layers 11, the first base member 10 can be produced while checking whether the first wiring line 30 is appropriately formed for each layer, so that the yield of the first base member 10 can be improved.

In the example illustrated in FIGs. 1 and 2, the first base member 10 includes four ceramic layers 11; however, the number of the ceramic layers 11 is not limited to four. The number of the ceramic layers 11 may be two or three, or may be five or more.

### Second Base Member

The second base member 20 is a base member including an organic component. The organic component may be an organic resin. The organic resin may be, for example, an epoxy resin, an acrylic resin, a polycarbonate resin, a polyimide resin, an olefin resin, a polyphenylene resin, or the like.

The organic resin may be, for example, polytetrafluoroethylene (PTFE), or other fluororesin or polyphenylene ether resin. The second base member 20 may include a component other than the organic resin. In the present disclosure, the organic resin may be, for example, a material that accounts for 30 mass% or more of the material constituting the second base member 20.

The second base member 20 includes a third surface 103 and a fourth surface 104 opposite to the third surface 103. The second base member 20 may be a plate-shaped body having the third surface 103 and the fourth surface 104 as main surfaces.

The wiring board 1 according to the embodiment includes two second base members 20. One of the two second base members 20 is bonded to the first surface 101 of the first base member 10, and the other is bonded to the second surface 102 of the first base member 10.

The second base member 20 located on the first surface 101 of the first base member 10 includes the third surface 103 bonded to the first surface 101 of the first base member 10, and the plurality of semiconductor elements 2 are mounted on the fourth surface 104 of the second base member 20 via the relay substrate 3 (see FIG. 1).

The second base member 20 located on the second surface 102 of the first base member 10 includes the third surface 103 bonded to the first surface 101 of the first base member 10, and the fourth surface 104 of the second base member 20 is bonded to the motherboard 4 via bonding portions 7.

The second base member 20 includes a plurality of organic resin layers 21. The plurality of organic resin layers 21 are layered along the thickness direction of the second base member 20. The wiring board 1 including such a second base member 20 has a high degree of freedom in design. In the example illustrated in FIG. 2, the second base member 20 includes four organic resin layers 21; however, the number of the organic resin layers 21 is not limited to four. The number of the organic resin layers 21 may be two or three, or may be five or more.

In the example illustrated in FIGs. 1 and 2, the wiring board 1 includes the second base member 20 on each of both main surfaces (the first surface 101 and the second surface 102) of the first base member 10. The wiring board 1 is not limited thereto, and may include the second base member 20 on at least the first surface 101 of the first base member 10.

The second base member 20 including an organic component is more likely to form a fine wiring pattern than an inorganic substrate. On the other hand, the first base member 10 made of ceramic has a higher rigidity than the second base member 20 and a lower density than the second base member 20.

The wiring board 1 according to the embodiment can increase the rigidity while achieving miniaturization and a narrow pitch of the wiring line by combining the first base member 10 and the second base member 20. Since the warpage of the substrate is more likely to be actualized as the substrate becomes larger, the configuration of the wiring board 1 in which the low rigidity of the second base member 20 is compensated for by the first base member 10 is particularly useful in increasing the size of the substrate.

The first base member 10 and the second base member 20 are bonded to each other by, for example, hydrogen bonding. Specifically, the first base member 10 and the second base member 20 are bonded to each other by bonding the hydroxyl groups of the first base member 10 and the second base member 20 to each other. In this case, a ceramic material such as alumina having a surface hydroxyl group may be used for the first base member 10, and an epoxy resin, which is a resin material including a hydroxyl group, may be used for the second base member 20. In this manner, the first base member 10 and the second base member 20 are directly bonded to each other without solder, underfill, or the like interposed therebetween, so that the thickness of the wiring board 1 can be suppressed and the manufacturing process can be facilitated.

The first base member 10 may include a glass component, and the second base member 20 may contain a coupling agent chemically bonding with the glass component. As the coupling agent, for example, a silane coupling agent can be used. As the coupling agent, a titanium-based coupling agent or an aluminum-based coupling agent can also be used. According to such a configuration, the first base member 10 and the second base member 20, which are different materials, can be more firmly bonded to each other by chemically bonding the first base member 10 and the second base member 20.

### First wiring line

The first wiring line 30 is a through-hole conductor located in the first base member 10. Specifically, the first wiring line 30 includes a through hole 31 penetrating the first base member 10 and a conductor 32. The conductor 32 includes metal as a main component and is located inside the through hole 31.

The first wiring line 30 includes a land portion 33 on the first surface 101 and the second surface 102 of the first base member 10.

### Second wiring line

The second wiring line 40 includes a plurality of vias 41 and one or more wiring layers 42. The via 41 penetrates one or more organic resin layers 21. The wiring layer 42 is located between the adjacent organic resin layers 21 and electrically connects the plurality of vias 41. The second wiring line 40 may include a land portion located on the fourth surface 104 of the second base member 20.

The first wiring line 30 and the second wiring line 40 may be, for example, metal conductors including copper or silver as a main component. For example, both the first wiring line 30 and the second wiring line 40 may be metal conductors including copper as a main component. Both the first wiring line 30 and the second wiring line 40 may be metal conductors including silver as a main component. One of the first wiring line 30 and the second wiring line 40 may be a metal conductor including copper as a main component, and the other may be a metal conductor including silver as a main component.

By using a metal conductor including copper or silver as a main component for all of the first wiring line 30 and the second wiring line 40, high electrical characteristics can be obtained compared to a case where, for example, one of the first wiring line 30 and the second wiring line 40 is a metal conductor other than copper and silver.

Out of the first wiring line 30 and the second wiring line 40, only the first wiring line 30 may include a glass component. In this case, the first wiring line 30 is firmly bonded to the first base member 10, which also includes a glass component, via the glass component. Therefore, the rigidity of the first base member 10 can be increased.

In a firing step in the production of the wiring board 1, the shrinkage rates of the first base member 10 and the first wiring line 30 can be made uniform to some extent, which can help prevent a position shift of the first wiring line 30.

The first wiring line 30 may be formed by, for example, printing a conductor paste containing copper and a glass component on a green sheet that is a raw material of the ceramic layer 11 and simultaneously firing the conductor paste and the green sheet. Specifically, the conductor paste may contain, for example, copper powder, borosilicate glass powder, and silica particles.

On the other hand, the second wiring line 40 may be formed by copper plating. Thus, out of the first wiring line 30 and the second wiring line 40, only the first wiring line 30 can be configured to include a glass component.

The second wiring line 40 may be electrically and thermally connected to the semiconductor element 2 via the relay substrate 3. The second wiring line 40 including copper or silver having a relatively high thermal conductivity as a main component is thermally connected to the semiconductor element 2 serving as a heat source, so that heat generated from the semiconductor element 2 can be efficiently released via the second wiring line 40 and the first wiring line 30.

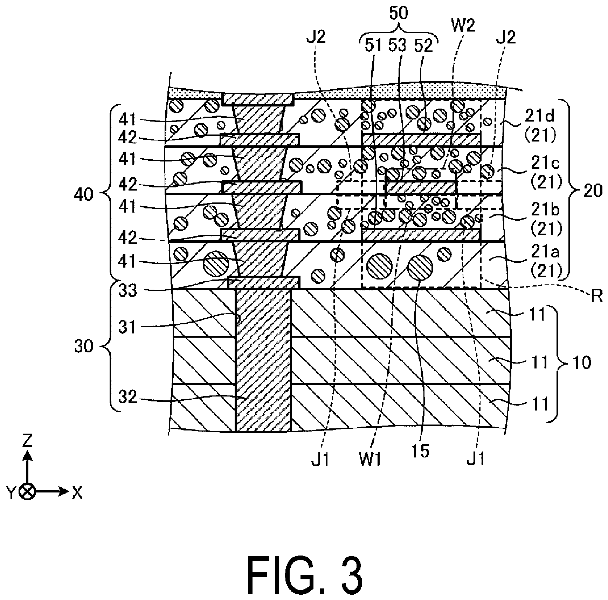

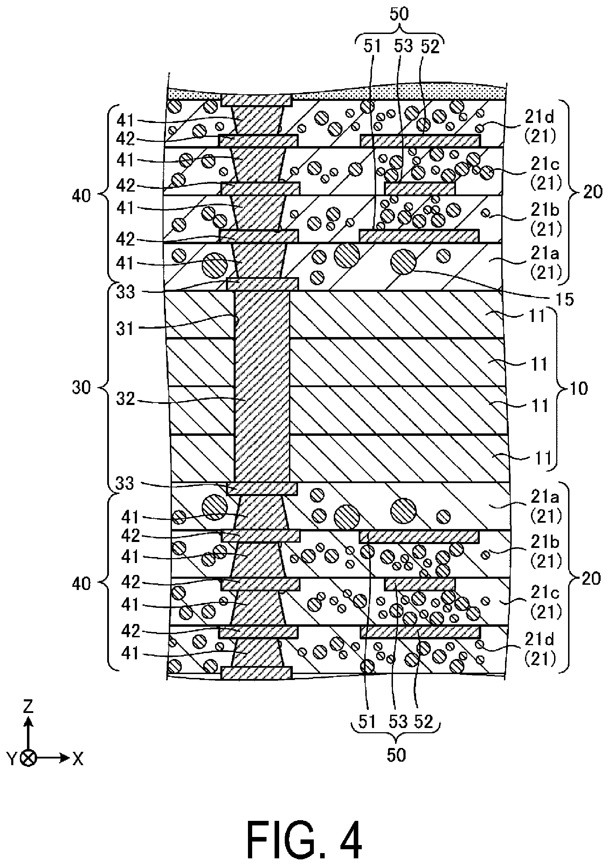

The configuration of the second base member 20 according to the embodiment is described with reference to FIGs. 3 and 4. FIG. 3 is a schematic cross-sectional view illustrating the configuration of the second base member 20 according to the embodiment. FIG. 4 is a schematic cross-sectional view illustrating the configuration of the first base member 10 and the second base member 20 according to the embodiment.

As described above, the second base member 20 includes the plurality of organic resin layers 21. Specifically, the plurality of organic resin layers 21 include a first layer 21a in contact with the first base member 10, and second layers 21b to 21d layered on the first layer 21a. In other words, the second layers 21b to 21d are all the organic resin layers 21 that are not in contact with the first base member 10 among the plurality of organic resin layers 21. In the second layers 21b to 21d, a first organic resin layer 21b, a second organic resin layer 21c, and a third organic resin layer 21d are layered in this order.

The wiring board 1 according to the embodiment may further include a third wiring line 50. The third wiring line 50 is located in the second layers 21b to 21d. The third wiring line 50 includes a first ground wiring line 51, a second ground wiring line 52, and a signal line 53.

Specifically, the first ground wiring line 51 is located in the first organic resin layer 21b and is connected to the ground. The second ground wiring line 52 is located in the third organic resin layer 21d and is connected to the ground. The signal line 53 is located in the second organic resin layer 21c and faces the first ground wiring line 51 and the second ground wiring line 52. The first ground wiring line 51 and the second ground wiring line 52 are so-called solid patterns, and have a larger lateral width (wiring line width) than the signal line 53.

As illustrated in FIG. 3, the second base member 20, that is, the first layer 21a and the second layers 21b to 21d (the first organic resin layer 21b, the second organic resin layer 21c, and the third organic resin layer 21d) include inorganic particles 15. The inorganic particles 15 are, for example, silica. The inorganic particles 15 are not limited to silica, and may be alumina, magnesium oxide, zirconia, calcium oxide, calcium carbonate, or the like.

The inorganic particles 15 reduce the dielectric loss of the second base member 20 made of an organic resin, and thus have an effect of improving the electrical characteristics of the second base member 20. However, when the inorganic particles 15 are located at an interface between the two organic resin layers 21, since a contact area between the organic resin layers 21 is reduced, the adhesiveness between the organic resin layers may be reduced.

In the wiring board 1 according to the embodiment, the content ratio of the inorganic particles 15 in an interface region where the organic resin layers 21 are bonded to each other is relatively reduced, thereby improving the adhesiveness between the organic resin layers 21.

For example, a region facing the third wiring line 50 (here, the signal line 53) in the interface region of the first organic resin layer 21b with the second organic resin layer 21c is defined as a first wiring region W1, and a region facing the second organic resin layer 21c in the interface region is defined as a first bonding region J1. In the wiring board 1 according to the embodiment, the content ratio of the inorganic particles 15 in the first bonding region J1 is lower than the content ratio of the inorganic particles 15 in the first wiring region W1. According to such a configuration, by setting the content ratio of the inorganic particles 15 in the first bonding region J1 where the first organic resin layer 21b and the second organic resin layer 21c are in direct contact with each other to be relatively low, the adhesiveness between the organic resin layers 21 can be improved. By setting the content ratio of the inorganic particles 15 in the first wiring region W1 where the first organic resin layer 21b and the signal line 53 are in contact with each other to be relatively high, the electrical characteristics of the second base member 20 can be enhanced by the inorganic particles 15. In this manner, in accordance with the wiring board 1 according to the embodiment, the adhesiveness between the organic resin layers 21 can be improved while enhancing the electrical characteristics of the second base member 20 by the inorganic particles 15.

As illustrated in FIG. 3, a region facing the third wiring line 50 (here, the signal line 53) in the interface region of the second organic resin layer 21c with the first organic resin layer 21b is defined as a second wiring region W2, and a region facing the first organic resin layer 21b in the interface region is defined as a second bonding region J2. In the wiring board 1 according to the embodiment, the content ratio of the inorganic particles 15 in the second bonding region J2 may be lower than the content ratio of the inorganic particles 15 in the second wiring region W2.

By setting the content ratio of the inorganic particles 15 in the second bonding region J2 to be lower than the content ratio of the inorganic particles 15 in the second wiring region W2 not only in the interface region of the first organic resin layer 21b but also in the interface region of the second organic resin layer 21c, the adhesiveness between the organic resin layers 21 can be further improved while enhancing the electrical characteristics of the second base member 20 by the inorganic particles 15.

Although not illustrated in the drawing, when a region facing the third wiring line 50 (here, the second ground wiring line 52) in the interface region of the second organic resin layer 21c with the third organic resin layer 21d is defined as a third wiring region W3 and a region facing the third organic resin layer 21d in the interface region is defined as a third bonding region J3, the content ratio of the inorganic particles 15 in the third bonding region J3 may be lower than the content ratio of the inorganic particles 15 in the third wiring region W3. Although not illustrated in the drawing, when a region facing the third wiring line 50 (here, the second ground wiring line 52) in the interface region of the third organic resin layer 21d with the second organic resin layer 21c is defined as a fourth wiring region W4 and a region facing the second organic resin layer 21c in the interface region is defined as a fourth bonding region J4, the content ratio of the inorganic particles 15 in the fourth bonding region J4 may be lower than the content ratio of the inorganic particles 15 in the fourth wiring region W4.

The content ratio of the inorganic particles 15 in the first wiring region W1 and the second wiring region W2 is preferably equal to or higher than 40 wt% and equal to or lower than 80 wt%. The average particle size of the inorganic particles 15 in the first wiring region W1 and the second wiring region W2 is preferably equal to or greater than 0.1 µm and equal to or less than 0.5 µm.

The maximum particle size of the inorganic particles 15 in the first wiring region W1 and the second wiring region W2 is preferably 10 times or less the average particle size. For example, when the average particle size of the inorganic particles 15 in the first wiring region W1 and the second wiring region W2 is 0.1 µm, the maximum particle size of the inorganic particles 15 is preferably 1 µm or less, and when the average particle size is 0.5 µm, the maximum particle size of the inorganic particles 15 is preferably 5 µm or less.

As illustrated in FIG. 3, in the organic resin layer 21 including the first organic resin layer 21b, the second organic resin layer 21c, and the third organic resin layer 21d, the content ratio of the inorganic particles 15 in a region R that overlaps any of the first ground wiring line 51, the signal line 53, and the second ground wiring line 52 in plan view may be higher than the content ratio of the inorganic particles 15 in a region that does not overlap any of the first ground wiring line 51, the signal line 53, and the second ground wiring line 52 in plan view.

When a strip line (a configuration in which a signal line is sandwiched between ground surfaces on the front and back sides via an insulation layer) is provided as a wiring line, the electrical characteristics of the strip line (the propagation speed of an electrical signal in the signal line) can be enhanced by relatively increasing the content ratio of the inorganic particles 15 in the region R where the strip line is located.

As illustrated in FIG. 4, the wiring board 1 according to the embodiment includes two second base members 20. One of the two second base members 20 is bonded to the first surface 101 of the first base member 10, and the other is bonded to the second surface 102 of the first base member 10. Although not illustrated in the drawing, in each of the two second base members 20, when a region facing the third wiring line 50 (here, the signal line 53) in the interface region of the first organic resin layer 21b with the second organic resin layer 21c is defined as a first wiring region W1 and a region facing the second organic resin layer 21c in the interface region is defined as a first bonding region J1, the content ratio of the inorganic particles 15 in the first bonding region J1 is lower than the content ratio of the inorganic particles 15 in the first wiring region W1. This makes it possible to improve the adhesiveness between the organic resin layers 21 while enhancing the electrical characteristics of the second base member 20 by the inorganic particles 15.

The two second base members 20 include the third wiring line 50 located in the second layers 21b to 21d, respectively. In this case, the third wiring line 50 located in the second base member 20 bonded to the first surface 101 of the first base member 10 and the third wiring line 50 located in the second base member 20 bonded to the second surface 102 are electrically connected via the conductor 32 penetrating the first base member 10. Thus, the third wiring line 50 can be made denser.

### Method for Manufacturing Second Base Member

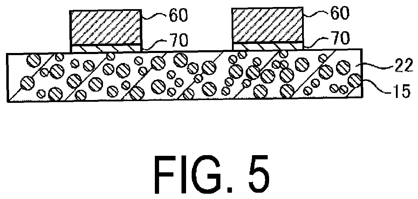

An example of a method for manufacturing the second base member 20 according to the embodiment, specifically, a method for forming the wiring region and the bonding region described above in the second base member 20 is described with reference to FIGs. 5 to 7. FIGs. 5 to 7 are schematic views for describing the method for manufacturing for the second base member 20 according to the embodiment. The second base member 20 is formed by layering, for example, four insulation layers (organic resin layers 21).

An organic resin sheet 22 is produced by first adjusting varnish obtained by adding the inorganic particles 15 such as silica, for example, to an epoxy resin and molding the varnish into a sheet shape.

The produced organic resin sheet 22 is attached onto the first base member 10. Subsequently, wiring lines are formed on the organic resin sheet 22. Among the wiring lines, the second wiring line 40 described above may be formed by, for example, forming a through hole in the organic resin sheet 22 by perforating the organic resin sheet 22 in the thickness direction thereof, and filling an inner portion of the through hole with a conductor paste.

As the conductor paste in this case, composite metal powder in which a low-melting-point metal is added to and mixed with copper or silver powder is preferably used as a conductor material, for example. Examples of the low-melting-point metal include tin (Sn), solder (Sn-Pb), bismuth (Bi), and antimony (Sb).

The conductor paste may include, as a binder, one or more organic resins selected from the group consisting of an epoxy resin, an acrylic resin, a polyethylene resin, and the like. The amount of the binder is desirably 1 to 20 parts by mass with respect to 100 parts by mass of the metal component.

The third wiring line 50 of the wiring lines may be formed by a so-called semi-additive method. In the semi-additive method, a seed layer is first formed on the surface of the organic resin sheet 22, and then a pattern is formed with a plating resist. The formed pattern is subjected to electrolytic copper plating, the plating resist is peeled off, and then only the seed layer is etched. In this manner, as illustrated in FIG. 5, a pattern (a copper plating 60 and a seed layer 70) is formed on the organic resin sheet 22.

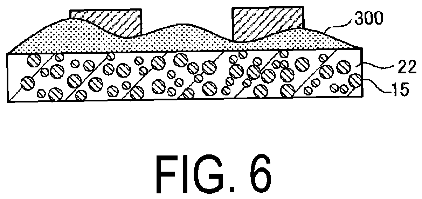

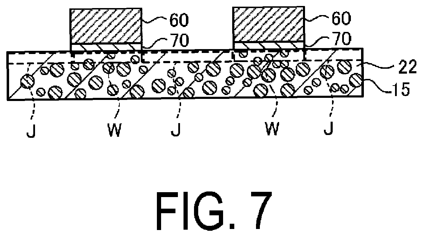

As illustrated in FIG. 6, an interface region of the organic resin sheet 22 on which the wiring lines are formed is etched with a nitrohydrofluoric acid 300. Thus, as illustrated in FIG. 7, the inorganic particles 15 included in the interface region of the organic resin sheet 22 are melted. In the interface region of the organic resin sheet 22, the inorganic particles 15 located immediately below the pattern do not come into contact with the nitrohydrofluoric acid 300, and thus remain in the organic resin sheet 22 without being melted by the nitrohydrofluoric acid 300. This results in the formation of, as illustrated in FIG. 7, an organic resin sheet 22 (hereinafter, referred to as a pattern sheet) having a region (bonding region J) where the content ratio of the inorganic particles 15 is relatively high and a region (wiring region W) where the content ratio of the inorganic particles 15 is relatively low.

Another pattern sheet is layered on the pattern sheet described above. The other pattern sheet is also subjected to an etching process with the nitrohydrofluoric acid 300 in advance, similarly to the pattern sheet described above. Accordingly, the bonding region J and the wiring region W are formed also on the surface of the other pattern sheet. In order to form the wiring region W on the other pattern sheet, for example, an etching process may be

performed in a state where a portion of the surface of the other pattern sheet, which is located immediately above the pattern formed on the pattern sheet described above, is covered with a mask. The present disclosure is not limited thereto, and the entire surface may be etched without forming a mask on another pattern sheet. In this case, the bonding region J is formed on the entire surface of the other pattern sheet.

After a plurality of pattern sheets are layered on the first base member 10 in this manner, the plurality of pattern sheets and the first base member 10 are heat-treated to produce a laminate body of the first base member 10 and the second base member 20.

When the plurality of pattern sheets are layered, a gap may be formed in the bonding region J depending on the layered state of the pattern sheets.

Note that the present technique can also have the following configurations.
(1) A wiring board (for example, the wiring board 1) includes a first base member (for example, the first base member 10), a second base member (for example, the second base member 20) that contains a plurality of inorganic particles (for example, the inorganic particles 15), is made of an organic resin, and is bonded to the first base member, and a wiring line (for example, the third wiring line 50) located in the second base member. The first base member has a higher rigidity than the second base member. The second base member includes a first organic resin layer (for example, the first organic resin layer 21b) and a second organic resin layer (for example, the second organic resin layer 21c) layered on the first organic resin layer. When a region facing the wiring line in an interface region of the first organic resin layer with the second organic resin layer is defined as a first wiring region (for example, the first wiring region W1) and a region facing the second organic resin layer in the interface region is defined as a first bonding region (for example, the first bonding region J1), a content ratio of the inorganic particles in the first bonding region is lower than a content ratio of the inorganic particles in the first wiring region.
(2) In the wiring board according to (1), when a region facing the wiring line in an interface region of the second organic resin layer with the first organic resin layer is defined as a second wiring region (for example, the second wiring region W2) and a region facing the first organic resin layer in the interface region is defined as a second bonding region (for example, the second bonding region J2), a content ratio of the inorganic particles in the second bonding region may be lower than a content ratio of the inorganic particles in the second wiring region.
(3) In the wiring board according to (1) or (2), the second base member may further include a third organic resin layer (for example, the third organic resin layer 21d) layered on the second organic resin layer, the wiring line may include a first ground wiring line (for example, the first ground wiring line 51) located in the first organic resin layer and is connected to a ground, a second ground wiring line (for example, the second ground wiring line 52) located in the third organic resin layer and is connected to the ground, and a signal line (for example, the signal line 53) located in the second organic resin layer and facing the first ground wiring line and the second ground wiring line, and a content ratio of the inorganic particles in a region (for example, the region R) of an organic resin layer including the first organic resin layer, the second organic resin layer, and the third organic resin layer, the region overlapping any of the first ground wiring line, the signal line, and the second ground wiring line in plan view, may be higher than a content ratio of the inorganic particles in a region of the organic resin layer not overlapping any of the first ground wiring line, the signal line, and the second ground wiring line in plan view.
(4) In the wiring board according to any one of (1) to (3), the first base member may be made of ceramic.
(5) In the wiring board according to any one of (1) to (4), the first base member may include a plurality of ceramic layers.
(6) The wiring board according to any one of (1) to (5) may include two second base members, the first base member may have a first surface (for example, the first surface 101) and a second surface (for example, the second surface 102) opposite to the first surface, and the second base members may be bonded to the first surface and the second surface, respectively.
(7) The wiring board according to (6) may include a conductor (for example, the conductor 32) penetrating the first surface and the second surface of the first base member, and the wiring line located in the second base member bonded to the first surface and the wiring line located in the second base member bonded to the second surface may be electrically connected via the conductor.
(8) In the wiring board according to any one of (1) to (7), the first base member may include a glass component, and the second base member may contain a coupling agent chemically bonding with the glass component.
(9) In the wiring board according to (1), the content ratio of the inorganic particles in the first wiring region may be equal to or higher than 40 wt% and equal to or lower than 80 wt%, an average particle size of the inorganic particles may be equal to or greater than 0.1 µm and equal to or less than 0.5 µm, and a maximum particle size of the inorganic particles may be equal to or less than 10 times the average particle size.
(10) The semiconductor device 100 may include the wiring board according to any one of (1) to (9) above, and a semiconductor element (for example, the semiconductor element 2) mounted over the second base member of the wiring board.

The embodiments disclosed herein should be considered exemplary in all respects and not restrictive. The embodiments described above may be embodied in various forms. The above-described embodiments may be omitted, substituted or modified in various forms without departing from the scope and spirit of the appended claims.

### REFERENCE SIGNS

1 Wiring board
2 Semiconductor element
3 Relay substrate
10 First base member
11 Ceramic layer
15 Inorganic particle
20 Second base member
21 Organic resin layer
21a First layer
21b First organic resin layer
21c Second organic resin layer
21d Third organic resin layer
30 First wiring line
40 Second wiring line
50 Third wiring line
51 First ground wiring line
52 Second ground wiring line
53 Signal line
100 Semiconductor device

## Claims

1. A wiring board comprising:
a first base member;
a second base member containing a plurality of inorganic particles, the second base member being made of an organic resin and being bonded to the first base member; and
a wiring line located in the second base member,
wherein the first base member has a higher rigidity than the second base member,
the second base member comprises a first organic resin layer and a second organic resin layer layered on the first organic resin layer, and
when a region facing the wiring line in an interface region of the first organic resin layer with the second organic resin layer is defined as a first wiring region and a region facing the second organic resin layer in the interface region is defined as a first bonding region, a content ratio of the inorganic particles in the first bonding region is lower than a content ratio of the inorganic particles in the first wiring region.

2. The wiring board according to claim 1, wherein, when a region facing the wiring line in an interface region of the second organic resin layer with the first organic resin layer is defined as a second wiring region and a region facing the first organic resin layer in the interface region is defined as a second bonding region, a content ratio of the inorganic particles in the second bonding region is lower than a content ratio of the inorganic particles in the second wiring region.

3. The wiring board according to claim 1 or 2,
wherein the second base member further comprises
a third organic resin layer layered on the second organic resin layer,
the wiring line comprises
a first ground wiring line located in the first organic resin layer and connected to a ground,
a second ground wiring line located in the third organic resin layer and connected to the ground, and
a signal line located in the second organic resin layer and facing the first ground wiring line and the second ground wiring line, and
a content ratio of the inorganic particles in a region of an organic resin layer comprising the first organic resin layer, the second organic resin layer, and the third organic resin layer, the region overlapping any of the first ground wiring line, the signal line, and the second ground wiring line in plan view, is higher than a content ratio of the inorganic particles in a region of the organic resin layer not overlapping any of the first ground wiring line, the signal line, and the second ground wiring line in plan view.

4. The wiring board according to any one of claims 1 to 3, wherein the first base member is made of ceramic.

5. The wiring board according to claim 4, wherein the first base member comprises a plurality of ceramic layers.

6. The wiring board according to claim 4 or 5, comprising:
two second base members each being the second base member,
wherein the first base member has
a first surface and
a second surface opposite to the first surface, and
the second base members are bonded to the first surface and the second surface, respectively.

7. The wiring board according to claim 6, further comprising:
a conductor penetrating the first surface and the second surface of the first base member,
wherein the wiring line located in the second base member bonded to the first surface and the wiring line located in the second base member bonded to the second surface are electrically connected via the conductor.

8. The wiring board according to any one of claims 4 to 7,
wherein the first base member contains a glass component, and
the second base member contains a coupling agent chemically bonding with the glass component.

9. The wiring board according to any one of claims 1 to 8,
wherein the content ratio of the inorganic particles in the first wiring region is equal to or higher than 40 wt% and equal to or lower than 80 wt%,
an average particle size of the inorganic particles is equal to or greater than 0.1 µm and equal to or less than 0.5 µm, and
a maximum particle size of the inorganic particles is equal to or less than 10 times the average particle size.

10. A semiconductor device comprising:
the wiring board according to any one of claims 1 to 9; and
a semiconductor element mounted over the second base member of the wiring board.
